# EUROPEAN PATENT APPLICATION

(11) **EP 4 756 460 A1**
(43) Date of publication of application: **10.06.2026**
(21) Application number: 24882583.8
(22) Date of filing: 24.07.2024
(51) Int. Cl.: G01R 31/396, G01R 31/385, G01R 31/3835, G01R 19/00, G01R 19/10, G01R 19/165, G01R 31/367, H01M 10/42, H01M 10/48

(54) **BATTERY DIAGNOSIS APPARATUS, BATTERY DIAGNOSIS METHOD, AND BATTERY DIAGNOSIS SYSTEM**

(30) Priority: 26.10.2023 KR 20230144484
(71) Applicant: LG Energy Solution, Ltd., Seoul 07335 (KR)
(72) Inventor: JEON, Young Hwan, Daejeon 34122 (KR); KIM, Ki Hoon, Daejeon 34122 (KR)
(74) Representative: Goddar, Heinz J.
(86) International application number: PCT/KR2024/010727
(87) International publication number: WO 2025/089554

(57) **Abstract**

A battery management apparatus according to some embodiments disclosed herein includes a sensor configured to collect battery data from a diagnosis target battery at intervals of a first time window each time when the diagnosis target battery enters a rest state and a controller configured to determine a short-term change of the diagnosis target battery during the first time window, based on current battery data measured in a current rest state, determine a long-term change of the diagnosis target battery between adjacent rest states, based on a difference between previous battery data measured in a previous rest state and the current battery data, and diagnose a state of the diagnosis target battery based on the short-term change and the long-term change.

## Description

### TECHNICAL FIELD

### CROSS-REFERENCE TO RELATED APPLICATION

This application claims priority to and the benefit of Korean Patent Application No. 10-2023-0144484 filed in the Korean Intellectual Property Office on October 26, 2023, the entire content of which is incorporated herein by reference.

### TECHNICAL FIELD

Embodiments disclosed herein relate to a battery diagnosis apparatus, a battery diagnosis method, and a battery diagnosis system.

### BACKGROUND ART

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Among secondary batteries, lithium-ion batteries may have a higher energy density than conventional Ni/Cd batteries, Ni/MH batteries, etc., and may be manufactured to be small and lightweight, allowing them to have high usability in terms of power sources for mobile devices. In addition, the lithium-ion battery is attracting attention as a next-generation energy storage medium as a usage range thereof is expanded to a power source of electric vehicles.

Fire accidents involving an electric vehicle (EV) tend to occur after battery charging or while parked rather than while driving. Generally, a battery of an EV may wake up periodically once a day to check a state thereof and then go back to a sleep state. As a diagnosis period increases, identification of a battery state may be missed, but when the battery wakes up more frequently, collision with other considerations may occur. It may be necessary to improve techniques for diagnosing a battery state and adjusting a wakeup period.

### DISCLOSURE

### TECHNICAL PROBLEM

Embodiments disclosed herein aim to provide a battery diagnosis apparatus, a battery diagnosis method, and a battery diagnosis system in which a battery state may be diagnosed and a wakeup period may be adjusted based on a short-term change and a long-term change in a rest state.

Technical problems of the embodiments disclosed herein are not limited to the above-described technical problems, and other unmentioned technical problems would be clearly understood by one of ordinary skill in the art from the following description.

### TECHNICAL SOLUTION

According to some embodiments disclosed herein, a battery management apparatus includes a sensor configured to collect battery data from a diagnosis target battery at intervals of a first time window each time when the diagnosis target battery enters a rest state and a controller configured to determine a short-term change of the diagnosis target battery during the first time window, based on current battery data measured in a current rest state, determine a long-term change of the diagnosis target battery between adjacent rest states, based on a difference between previous battery data measured in a previous rest state and the current battery data, and diagnose a state of the diagnosis target battery based on the short-term change and the long-term change.

According to some embodiments, the sensor may be further configured to collect a plurality of open circuit voltage (OCV) values from a plurality of battery cells of the diagnosis target battery, and the controller may be further configured to diagnose the state of the diagnosis target battery based on the short-term change and the long-term change of the plurality of OCV values.

According to some embodiments, the controller may be further configured to calculate a plurality of OCV deviations based on differences between the plurality of OCV values and an average every entrance to the rest state and diagnose a state of the diagnosis target battery based on a short-term difference of an OCV deviation of each battery cell during the first time window and a long-term difference between the previous rest state and the current rest state.

According to some embodiments, the controller may be further configured to calculate the OCV deviation by calculating an average of values except for an abnormal value among a plurality of OCV deviations repetitively measured for each battery cell.

According to some embodiments, the controller may be further configured to increase a diagnosis count in the current rest state of each battery cell when the short-term difference exceeds a short-term threshold value or the long-term difference exceeds a long-term threshold value and diagnose the diagnosis target battery as a failure when the diagnosis count is greater than or equal to a final count.

According to some embodiments, the controller may be further configured to shorten an analysis interval of the short-term change from the first time window to a second time window that is shorter than the first time window, when the diagnosis count is greater than or equal to a first mid count that is less than the final count.

According to some embodiments, the controller may be further configured to reduce at least one of the short-term threshold value and the long-term threshold value that are criteria for increasing the diagnosis count when the diagnosis count is greater than or equal to a second mid count that is less than the final count.

According to some embodiments disclosed herein, a battery diagnosis method includes collecting battery data from a diagnosis target battery at intervals of a first time window each time when the diagnosis target battery enters a rest state, determining a short-term change of the diagnosis target battery during the first time window, based on current battery data measured in a current rest state, determining a long-term change of the diagnosis target battery between adjacent rest states, based on a difference between previous battery data measured in a previous rest state and the current battery data, and diagnosing a state of the diagnosis target battery based on the short-term change and the long-term change.

According to some embodiments, the collecting of the battery data may include collecting a plurality of open circuit voltage (OCV) values from a plurality of battery cells of the diagnosis target battery, and the diagnosing of the state may include diagnosing the state of the diagnosis target battery based on the short-term change and the long-term change of the plurality of OCV values OCV1 to OCVn.

According to some embodiments, the diagnosing of the state may include calculating a plurality of OCV deviations based on differences between the plurality of OCV values and an average every entrance to the rest state and diagnosing a state of the diagnosis target battery based on a short-term difference of an OCV deviation of each battery cell during the first time window and a long-term difference between the previous rest state and the current rest state.

According to some embodiments, the calculating of the plurality of OCV deviations may include calculating the OCV deviation by calculating an average of values except for an abnormal value among a plurality of OCV deviations repetitively measured for each battery cell.

According to some embodiments, the diagnosing of the state may include increasing a diagnosis count in the current rest state of each battery cell when the short-term difference exceeds a short-term threshold value or the long-term difference exceeds a long-term threshold value and diagnosing the diagnosis target battery as a failure when the diagnosis count is greater than or equal to a final count.

According to some embodiments, the battery diagnosis method may further include shortening an analysis interval of the short-term change from the first time window to a second time window that is shorter than the first time window, when the diagnosis count is greater than or equal to a first mid count that is less than the final count.

According to some embodiments, the battery diagnosis method may further include reducing at least one of the short-term threshold value and the long-term threshold value that are criteria for increasing the diagnosis count when the diagnosis count is greater than or equal to a second mid count that is less than the final count.

According to some embodiments disclosed herein, a battery diagnosis system includes a diagnosis target battery and a battery diagnosis apparatus configured to collect battery data from a diagnosis target battery at intervals of a first time window each time when the diagnosis target battery enters a rest state, determine a short-term change of the diagnosis target battery during the first time window, based on current battery data measured in a current rest state, determine a long-term change of the diagnosis target battery between adjacent rest states, based on a difference between previous battery data measured in a previous rest state and the current battery data, and diagnose a state of the diagnosis target battery based on the short-term change and the long-term change.

### ADVANTAGEOUS EFFECTS

According to embodiments disclosed herein, there may be provided a battery diagnosis apparatus, a battery diagnosis method, and a battery diagnosis system in which a battery state may be diagnosed and a wakeup period may be adjusted based on a short-term change and a long-term change in a rest state.

The technical effects according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 illustrates components of a battery diagnosis system according to some embodiments.
FIG. 2 illustrates components of a battery diagnosis apparatus according to some embodiments.
FIG. 3 illustrates an operating process of a battery diagnosis apparatus according to some embodiments.
FIG. 4 illustrates a process of adjusting a wakeup period and count threshold values based on a diagnosis count, according to some embodiments.
FIG. 5 illustrates setting values for adjusting a wakeup period and count threshold values, according to some embodiments.
FIG. 6 illustrates operations of a battery diagnosis method according to some embodiments.

### MODE FOR INVENTION

Hereinafter, embodiments disclosed herein will be described with reference to the accompanying drawings. However, the description is not intended to limit the disclosure of the present document to particular embodiments, and it should be construed as including various modifications, equivalents, and/or alternatives according to the embodiments described herein.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two driver devices directly. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

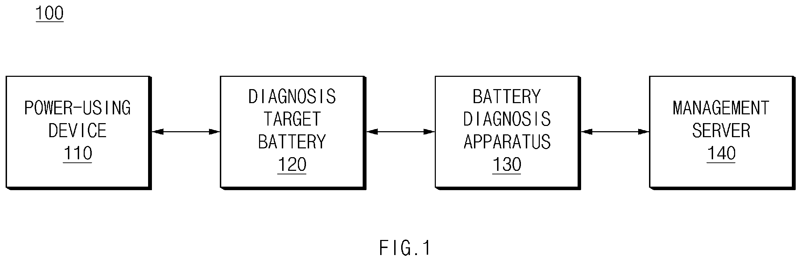

FIG. 1 illustrates components of a battery management system according to some embodiments.

Referring to FIG. 1, a battery diagnosis system 100 may include a power-using device 110, a diagnosis target battery 120, a battery diagnosis apparatus 130, and a management server 140. However, without being limited thereto, some components may be omitted from the battery diagnosis system 100 or other general-purpose components may be further included in the battery diagnosis system 100.

The battery diagnosis system 100 may refer to a system for diagnosing the diagnosis target battery 120 and managing a state thereof. When the diagnosis target battery 120 is charged or discharged by the power-using device 110, corresponding battery data of the diagnosis target battery 120 may be measured and analyzed by the battery diagnosis apparatus 130.

The power-using device 110 may be configured to charge or discharge the diagnosis target battery 120. The power-using device 110 may discharge the diagnosis target battery 120 while consuming power, and charge the diagnosis target battery 120 while generating power. According to an embodiment, the power-using device 110 may include a mobility device such as an electric vehicle (EV), a hybrid EV (HEV), electric bike, etc. The mobility device may drive a motor based on power of the diagnosis target battery 120 or charge the diagnosis target battery 120 with power generated through regenerative breaking.

The diagnosis target battery 120 may include a battery pack, etc., that is a target for diagnosis of the battery diagnosis system 100. A battery pack of the diagnosis target battery 120 may include a plurality of battery modules, and each battery module may include a plurality of battery cells. According to an embodiment, the diagnosis target battery 120 may be mounted on mobility devices of various types.

The battery diagnosis apparatus 130 may perform operations for diagnosing or managing the diagnosis target battery 120. The battery diagnosis apparatus 130 may measure battery data from the diagnosis target battery 120 and diagnose or manage a state of the diagnosis target battery 120 based on the battery data.

The management server 140 may manage a result of diagnosis of the battery diagnosis apparatus 130. The management server 140 may exchange data with the battery diagnosis apparatus 130 in a wired/wireless communication manner. When a failure of the diagnosis target battery 120 is diagnosed or a lifespan thereof is predicted, corresponding results may be transmitted to the management server 140 and recorded in a database.

According to an embodiment, the management server 140 may perform operations for managing the diagnosis target battery 120, in place of the battery diagnosis apparatus 130. According to an embodiment, the battery diagnosis apparatus 130 may perform diagnosis operations by executing battery management software, and the management server 140 may provide update information of the battery management software to the battery diagnosis apparatus 130.

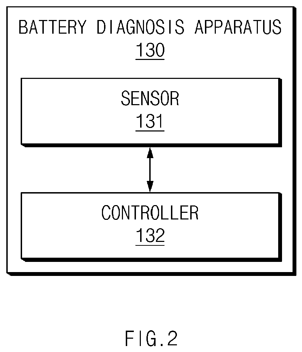

FIG. 2 illustrates components of a battery diagnosis apparatus according to some embodiments.

Referring to FIG. 2, the battery diagnosis apparatus 130 may include a sensor 131 and a controller 132. However, without being limited thereto, some components may be omitted from the battery diagnosis apparatus 130 or other general-purpose components may be further included in the battery diagnosis apparatus 130.

According to an embodiment, the sensor 131 and the controller 132 of the battery diagnosis apparatus 130 may be electrically connected to one another in a device-to-device communication manner. The device-to-device communication manner may include a general-purpose input and output (GPIO), a serial peripheral interface (SPI), a mobile industry processor interface (MIPI), etc.

The sensor 131 may be configured to generate various battery measurement values from the diagnosis target battery 120. To this end, the sensor 131 may include measuring means such as a voltage sensor, a current sensor, a temperature sensor, etc.

The controller 132 may have a structure for executing instructions that implement the operations of the battery diagnosis apparatus 130. The controller 132 may be implemented with an array of multiple logic gates or a general-purpose microprocessor for processing various operations, and may include a single processor or a plurality of processors. For example, the controller 132 may be implemented in the form of at least one of a microprocessor, a CPU, a GPU, and an AP.

The controller 132 may operate with a memory configured to store various data, instructions, mobile applications, computer programs, etc. The memory may be configured separately from or integrally with the controller 132. The controller 132 may execute instructions stored in the memory to process various calculation. For example, the memory may be implemented in the form of a non-volatile memory device such as ROM, PROM, EPROM, EEPROM, flash memory, PRAM, MRAM, RRAM, FRAM, etc., a volatile memory device such as DRAM, SRAM, SDRAM, RRAM, etc., or HDD, SSD, SD, Micro- SD, etc., or may be implemented in the form of a combination thereof.

The sensor 131 may be configured to collect battery data from the diagnosis target battery 120 at intervals of a first time window each time when the diagnosis target battery 120 enters the rest state. For example, the diagnosis target battery 120 may be mounted on the power-using device 110 such as the EV, etc., and the diagnosis target battery 120 of the EV may enter the rest state every evening after work. When the diagnosis target battery 120 enters the rest state every evening (8 p.m., etc.), the battery data may be collected at intervals of the first time window. For example, when the diagnosis target battery 120 enters the rest state at 8 p.m., the battery data may be collected at 10 p.m. on that day and 2 a.m. on the next day, and in this case, the first time window may be 4 hours.

The controller 132 may be configured to determine a short-term change during the first time window of the diagnosis target battery 120 based on current battery data measured in the current rest state. For example, the current rest state may mean a today's rest state, and a previous rest state may mean a yesterday's rest state. When the diagnosis target battery 120 enters the rest state at 8 p.m. and the battery data is collected at 10 p.m. on that day and 2 a.m. on the next day, a short-term change during the first time window of 4 hours may be determined. For example, the short-term change may be determined based on a change of OCV values of cells of the diagnosis target battery 120 during the first time window.

The controller 132 may be configured to determine a long-term change between adjacent rest states of the diagnosis target battery 120 based on a difference between previous battery data measured in a previous rest state and the current battery data. For example, when the previous rest state occurs yesterday afternoon and the current rest state occurs this afternoon, then the long-term change may be determined based on a state change between yesterday afternoon and this afternoon. For example, the long-term change may be determined based on a change of OCV values of cells of the diagnosis target battery 120.

The controller 132 may be configured to diagnose the state of the diagnosis target battery 120 based on short-term and long-term changes. For example, a count value of the diagnosis target battery 120 may increase or decrease by 1 according to whether the short-term change and/or the long-term change exceeds a threshold value, and diagnose a final state of the diagnosis target battery 120 based on a cumulative value of the count value.

According to an embodiment, the sensor 131 may be configured to collect a plurality of open circuit voltage values OCV1 to OCVn from a plurality of battery cells c1 to cn of the diagnosis target battery 120, and the controller 132 may be configured to diagnose a state of the diagnosis target battery 120 based on a short-term change and a long-term change of the plurality of OCV values OCV1 to OCVn. The diagnosis target battery 120 may include n battery cells c1 to cn, and short-term and long-term changes may be calculated based on n OCV values (OCV1 to OCVn. Thus, diagnosis by the battery diagnosis apparatus 130 may be performed on a cell-by-cell basis.

According to an embodiment, the controller 132 may be configured to calculate a plurality of OCV deviations dV1 to dVn based on differences between the plurality of OCV values OCV1 to OCVn and an average value OCVavr and diagnose the state of the diagnosis target battery 120 based on a short-term difference ΔdVS of an OCV deviation dVi of each battery cell ci during the first time window and a long-term difference ΔdVL between the previous rest state and the current rest state, every entrance to the rest state. The short-term difference ΔdVS of each battery cell ci may indicate a difference between the OCV deviation dVi at the start of the first time window and the OCV deviation dVi at the end of the first time window. The long-term difference ΔdVL of each battery cell ci may indicate a difference between the OCV deviation dVi in the previous rest state and the OCV deviation dVi in the current rest state.

According to an embodiment, the controller 132 may be configured to calculate the OCV deviation dVi by calculating an average of values except for abnormal values among a plurality of OCV deviations repetitively measured for each battery cell ci. For example, 10 OCV deviations may be generated through 10 times of measurement, and when there is an abnormal value having an obvious error among them, the OCV deviation dVi may be calculated as an average of the remaining values other than the abnormal value. A criterion for determining an abnormal value may be 2 sigma, 3 sigma, or any other appropriate value.

According to an embodiment, the controller 132 may be configured to increase a diagnosis count in the current rest state of each battery cell ci when the short-term difference ΔdVS exceeds a short-term threshold value or the long-term difference ΔdVL exceeds a long-term threshold value, and to diagnose the diagnosis target battery 120 as a failure when the diagnosis count is greater than or equal to a final count. For example, the diagnosis count may increase by 1 each time when the short-term difference ΔdVS exceeds a short-term threshold value or the long-term difference ΔdVL exceeds a long-term threshold value, and when the diagnosis count is 5, the diagnosis target battery 120 may be finally diagnosed as a failure. According to an embodiment, when the diagnosis count does not exceed either the short-term threshold value or the long-term threshold value in the current rest state, the diagnosis count may decrease by 1.

According to an embodiment, the controller 132 may be configured to shorten an analysis interval of the short-term change from the first time window to a second time window that is shorter than the first time window, when the diagnosis count is greater than or equal to a first mid count that is less than the final count. For example, the first time window may be 4 hours when the diagnosis count is 0, the first time window may be shortened to the second time window when the diagnosis count is 1 or 2, and the second time window may be 2 hours. In addition, when the diagnosis count is 1 or 2, the second time window may be shortened to a third time window that may be 1 hour. As such, by shortening the wakeup period of the diagnosis target battery 120, fire may be prevented from occurring in the battery due to a delay in the analysis of the battery.

According to an embodiment, the controller 132 may be configured to reduce at least one of the short-term threshold value and the long-term threshold value that are criteria for increasing the diagnosis count when the diagnosis count is greater than or equal to the second mid count that is less than the final count. For example, when the diagnosis count is 0, the short-term threshold value may be 3 mV and the long-term threshold value may be 5 mV. When the diagnosis count increases, the short-term threshold value and/or the long-term threshold value may decrease and thus tighter diagnosis may be performed.

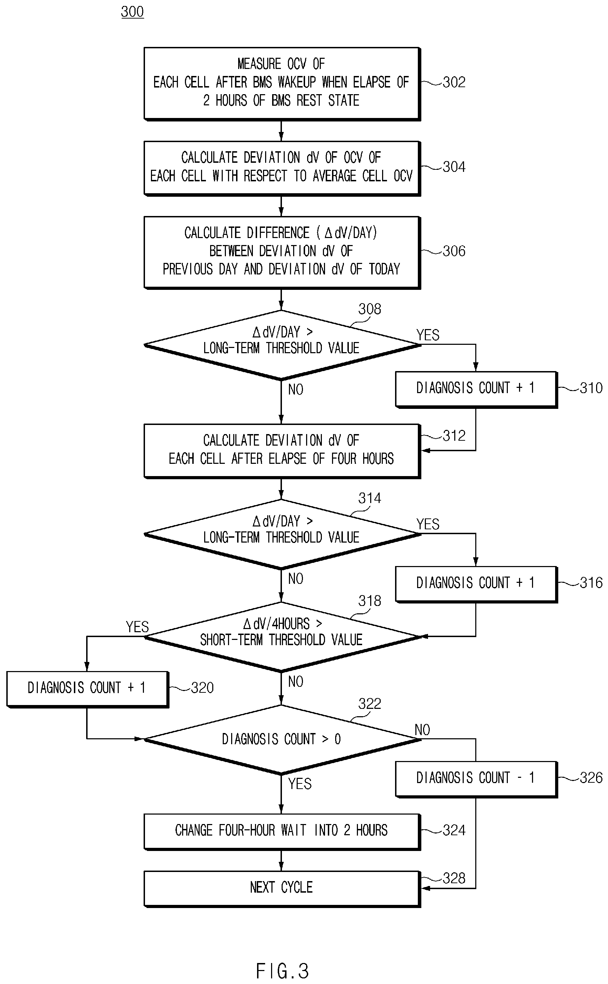

FIG. 3 illustrates an operating process of a battery diagnosis apparatus according to some embodiments.

Referring to FIG. 3, a flow 300 showing an operating process of a battery diagnosis apparatus is shown. The flow 300 may indicate an algorithm performed in one rest state.

When 2 hours elapse from entrance to the current rest state, an OCV of each cell may be measured in operation 302, and a deviation dV of the OCV of each cell with respect to a cell average OCV may be calculated in operation 304. Thereafter, in operation 306, a difference (ΔdV/day) between the OCV deviation dV at the time when 2 hours elapse from entrance to the previous rest state (the previous day) and the current OCV deviation dV may be calculated.

The difference (ΔdV/day) may be compared with the long-term threshold value in operation 308, and when the difference (ΔdV/day) exceeds the long-term threshold value, the diagnosis count may increase by 1 in operation 310. In operation 312, after the first time window elapses, the OCV deviation dV of each cell may be calculated and the first time window may be 4 hours. In operation 314, the difference (ΔdV/day) between the current OCV deviation dV and the OCV deviation dV at the time when 6 hours elapse from entrance to the previous rest state (the previous day) may be calculated and compared with the long-term threshold value.

In operation 316, when the difference (ΔdV/day) exceeds the long-term threshold value, the diagnosis count may increase by 1. In operation 318, a difference (ΔdV/4hours) of the OCV deviation dV during the first time window may be compared with the short-term threshold value. In operation 320, when the difference (ΔdV/4hours) exceeds the short-term threshold value, the diagnosis count may increase by 1.

When comparison with the long-term threshold value two times and comparison with the short-term threshold value once are completed, it may be determined whether the current value of the diagnosis count exceeds 0 in operation 322. When the current value exceeds 0, the first time window may be shortened to the second time window in operation 324. When the current value does not exceed 0, the diagnosis count may decrease by 1 in operation 326. In operation 328, a cycle for the current rest state may be terminated. When the mobility device newly enters the rest state on the next day, operation 302 may be performed again.

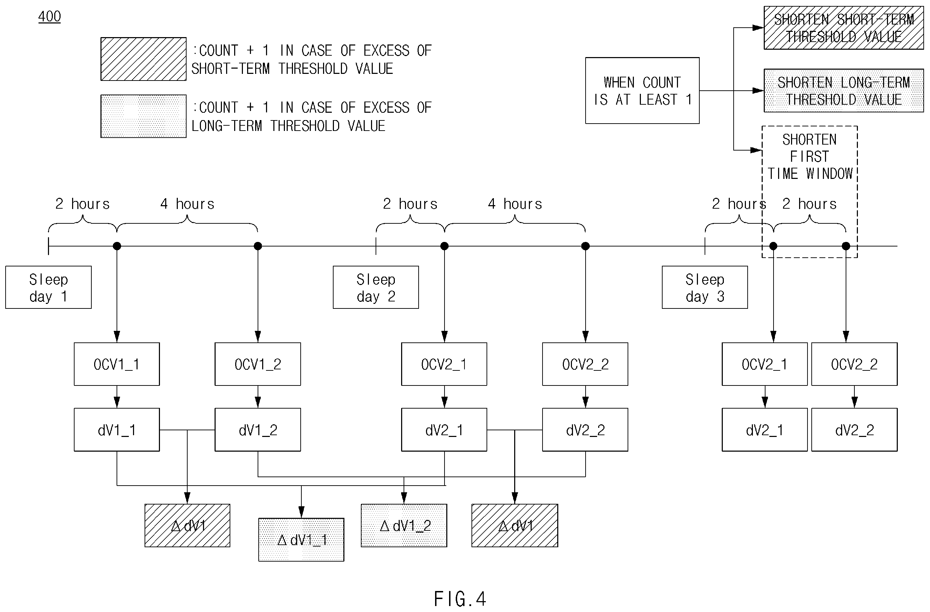

FIG. 4 illustrates a process of adjusting a wakeup period and count threshold values based on a diagnosis count, according to some embodiments.

Referring to FIG. 4, a block diagram 400 showing a process of adjusting a wakeup period and count threshold values based on a diagnosis count is shown.

In the block diagram 400, upon entrance to a first-day rest state (Sleep day 1), after a wait for 2 hours, an OCV value of each cell may be measured (OCV_1), and an OCV deviation of each cell may be calculated based on an average of OCV values of a plurality of cells (dV1_1). Thereafter, after a wait for the first time window, second measurement may be performed. The first time window may be 4 hours, and may be changed to another value when necessary. An OCV value of each cell and an OCV deviation may be calculated in the second measurement (OCV1_2, dV1_2).

The difference ΔdV1 of the OCV deviation during the first time window may be compared with the short-term threshold value. Meanwhile, the OCV deviations OCV1_1 and OCV1_2 before and after the first time window may be compared with OCV deviations OCV2_1 and OCV2_2 in the next rest state, and differences therebetween may be calculated as long-term differences AdV1_1 and AdV1_2. The long-term differences AdV1_1 and AdV1_2 may be compared with the long-term threshold value. According to an embodiment, the short-term change or the short-term difference may indicate a difference during a relatively short time such as 4 hours, 2 hours, 1 hour, etc., and the long-term change or the long-term difference may indicate a difference during a relatively long time. For example, the difference during the relatively long time may be a time between adjacent rest periods of the mobility device having the diagnosis target battery 120 mounted thereon, and may be 10 hours, 12 hours, 24 hours, or a time longer than that of the short-term change.

After completion of a second-day rest state (Sleep day 2), when the diagnosis count is greater than or equal to 1, the first time window of 4 hours may be shortened to the second time window of 2 hours in a third-day rest state (Sleep day 3) and the long-term threshold value and the short-term threshold value may decrease. In this way, when a failure of the diagnosis target battery 120 is suspected because the diagnosis count is greater than or equal to 1, diagnosis parameters such as a wakeup period, etc., may be adjusted for tighter diagnosis.

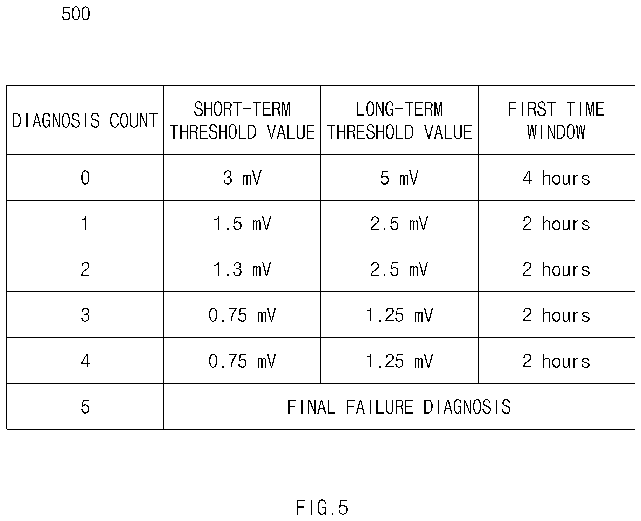

FIG. 5 illustrates setting values for adjusting a wakeup period and count threshold values, according to some embodiments.

Referring to FIG. 5, a table 500 showing setting values for adjusting a wakeup period and count threshold values is shown. Values on the table 500 are merely examples, and other values may be used according to diagnosis performance.

On the table 500, when the diagnosis count is 0, the short-term threshold value may be 3 mV, the long-term threshold value may be 5 mV, and the first time window may be 4 hours. When the diagnosis count is 1 or 2, each of the short-term threshold value, the long-term threshold value, and the first time window may be shortened to a half.

Moreover, when the diagnosis count is 3 or 4, each of the short-term threshold value and the long-term threshold value may be further shortened to a half. In this way, the wakeup period and the count threshold values may be adjusted, such that when a battery failure is suspected, a criterion for battery diagnosis may be adaptively changed.

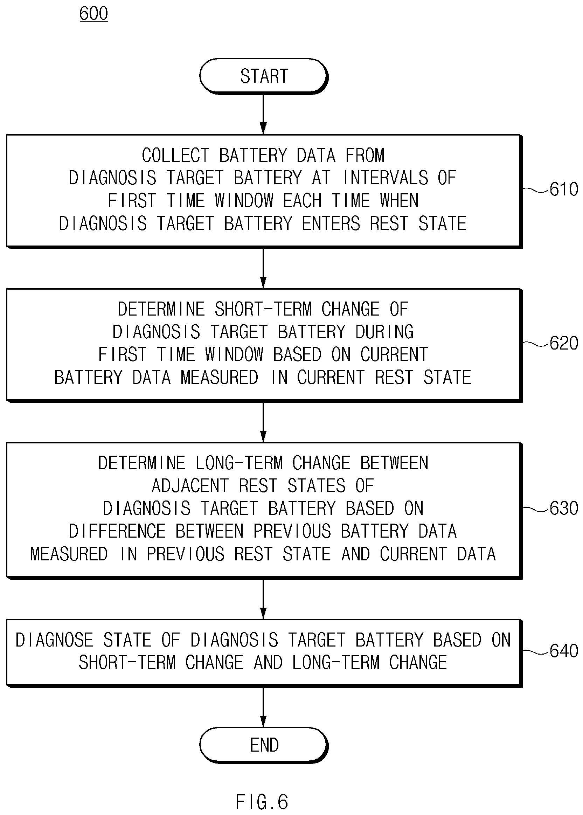

FIG. 6 illustrates operations of a battery diagnosis method according to some embodiments.

Referring to FIG. 6, a battery diagnosis method 600 may include operations 610 to 640. However, without being limited thereto, some operations may be omitted and other general-purpose operations may be added, and operations of the battery diagnosis method 600 may be executed in an order different from that shown.

The battery diagnosis method 600 may include operations processed in time series by the battery diagnosis apparatus 130. Therefore, matters described for the battery diagnosis apparatus 130 above, even omitted below, may be equally applied to the battery diagnosis method 600.

Operations 610 to 640 of the battery diagnosis method 600 may be performed by the sensor 131 and the controller 132 of the battery diagnosis apparatus 130.

In operation 610, the battery diagnosis apparatus 130 may collect battery data from a diagnosis target battery at intervals of a first time window each time when the diagnosis target battery enters a rest state. In operation 620, the battery diagnosis apparatus 130 may determine a short-term change of the diagnosis target battery during the first time window based on the current battery data measured in the current rest state.

In operation 630, the battery diagnosis apparatus 130 may determine a long-term change between adjacent rest states of the diagnosis target battery based on a difference between previous battery data measured in the previous rest state and the current battery data. In operation 640, the battery diagnosis apparatus 130 may diagnose a state of the diagnosis target battery based on the short-term change and the long-term change.

According to an embodiment, the battery diagnosis method 600 may be implemented in the form of a computer program stored in a computer-readable storage medium. That is, the computer program may include instructions for implementing the battery diagnosis method 600, and the instructions of the program may be stored in a computer-readable storage medium. The computer programs may include mobile applications.

According to an embodiment, the computer-readable storage medium may include magnetic media such as hard disk, floppy disk, and magnetic tape, optical media such as compact disk read only memory (CD-ROM) and digital versatile disk (DVD), magneto-optical media such as floptical disk, and a hardware device especially configured to store and execute program instructions, such as ROM, RAM and flash memory, etc. The computer program instructions may include a machine language code created by a complier and a high-level language code executable by a computer using an interpreter.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

### [EXPLANATION OF REFERENCE NUMERALS]

| | | | |
|---|---|---|---|
| 100: | Battery Diagnosis System | 110: | Power-Using Device |
| 120: | Diagnosis Target Battery | 130: | Battery Diagnosis Apparatus |
| 131: | Sensor | 132: | Controller |
| 140: | Management Server | | |

## Claims

1. A battery diagnosis apparatus comprising:
a sensor configured to collect battery data from a diagnosis target battery at intervals of a first time window each time when the diagnosis target battery enters a rest state; and
a controller configured to:
determine a short-term change of the diagnosis target battery during the first time window, based on current battery data measured in a current rest state;
determine a long-term change of the diagnosis target battery between adjacent rest states, based on a difference between previous battery data measured in a previous rest state and the current battery data; and
diagnose a state of the diagnosis target battery based on the short-term change and the long-term change.

2. The battery diagnosis apparatus of claim 1, wherein the sensor is further configured to collect a plurality of open circuit voltage (OCV) values from a plurality of battery cells of the diagnosis target battery, and
the controller is further configured to diagnose the state of the diagnosis target battery based on the short-term change and the long-term change of the plurality of OCV values.

3. The battery diagnosis apparatus of claim 2, wherein the controller is further configured to:
calculate a plurality of OCV deviations based on differences between the plurality of OCV values and an average every entrance to the rest state; and
diagnose a state of the diagnosis target battery based on a short-term difference of an OCV deviation of each battery cell during the first time window and a long-term difference between the previous rest state and the current rest state.

4. The battery diagnosis apparatus of claim 3, wherein the controller is further configured to calculate the OCV deviation by calculating an average of values except for an abnormal value among a plurality of OCV deviations repetitively measured for each battery cell.

5. The battery diagnosis apparatus of claim 3, wherein the controller is further configured to:
increase a diagnosis count in the current rest state of each battery cell when the short-term difference exceeds a short-term threshold value or the long-term difference exceeds a long-term threshold value; and
diagnose the diagnosis target battery as a failure when the diagnosis count is greater than or equal to a final count.

6. The battery diagnosis apparatus of claim 5, wherein the controller is further configured to shorten an analysis interval of the short-term change from the first time window to a second time window that is shorter than the first time window, when the diagnosis count is greater than or equal to a first mid count that is less than the final count.

7. The battery diagnosis apparatus of claim 5, wherein the controller is further configured to reduce at least one of the short-term threshold value and the long-term threshold value that are criteria for increasing the diagnosis count when the diagnosis count is greater than or equal to a second mid count that is less than the final count.

8. A battery diagnosis method comprising:
collecting battery data from a diagnosis target battery at intervals of a first time window each time when the diagnosis target battery enters a rest state;
determining a short-term change of the diagnosis target battery during the first time window, based on current battery data measured in a current rest state;
determining a long-term change of the diagnosis target battery between adjacent rest states, based on a difference between previous battery data measured in a previous rest state and the current battery data; and
diagnosing a state of the diagnosis target battery based on the short-term change and the long-term change.

9. The battery diagnosis method of claim 8, wherein the collecting of the battery data comprises collecting a plurality of open circuit voltage (OCV) values from a plurality of battery cells of the diagnosis target battery, and
the diagnosing of the state comprises diagnosing the state of the diagnosis target battery based on the short-term change and the long-term change of the plurality of OCV values OCV1 to OCVn.

10. The battery diagnosis method of claim 8, wherein the diagnosing of the state comprises:
calculating a plurality of OCV deviations based on differences between the plurality of OCV values and an average every entrance to the rest state; and
diagnosing a state of the diagnosis target battery based on a short-term difference of an OCV deviation of each battery cell during the first time window and a long-term difference between the previous rest state and the current rest state.

11. The battery diagnosis method of claim 10, wherein the calculating of the plurality of OCV deviations comprises calculating the OCV deviation by calculating an average of values except for an abnormal value among a plurality of OCV deviations repetitively measured for each battery cell.

12. The battery diagnosis method of claim 10, wherein the diagnosing of the state comprises:
increasing a diagnosis count in the current rest state of each battery cell when the short-term difference exceeds a short-term threshold value or the long-term difference exceeds a long-term threshold value; and
diagnosing the diagnosis target battery as a failure when the diagnosis count is greater than or equal to a final count.

13. The battery diagnosis method of claim 12, further comprising shortening an analysis interval of the short-term change from the first time window to a second time window that is shorter than the first time window, when the diagnosis count is greater than or equal to a first mid count that is less than the final count.

14. The battery diagnosis method of claim 12, further comprising reducing at least one of the short-term threshold value and the long-term threshold value that are criteria for increasing the diagnosis count when the diagnosis count is greater than or equal to a second mid count that is less than the final count.

15. A battery diagnosis system comprising:
a diagnosis target battery; and
a battery diagnosis apparatus configured to collect battery data from a diagnosis target battery at intervals of a first time window each time when the diagnosis target battery enters a rest state, determine a short-term change of the diagnosis target battery during the first time window, based on current battery data measured in a current rest state, determine a long-term change of the diagnosis target battery between adjacent rest states, based on a difference between previous battery data measured in a previous rest state and the current battery data, and diagnose a state of the diagnosis target battery based on the short-term change and the long-term change.
